(19) Europäisches Patentamt
European Patent Office
Office européen des brevets

(11) **EP 1 804 121 A1**

(12) **EUROPEAN PATENT APPLICATION**

(43) Date of publication:
**04.07.2007 Bulletin 2007/27**

(51) Int Cl.:
***G03F 7/20*** (2006.01)

(21) Application number: **05078032.9**

(22) Date of filing: **29.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Interuniversitair Microelektronica Centrum**
**3001 Leuven (BE)**

(72) Inventors:
• **Pollentier, Ivan**
  **3201 Langdorp (BE)**
• **Foubert, Philippe**
  **3052 Blanden (BE)**

(74) Representative: **Bird, William Edward et al**
**Bird Goen & Co.,**
**Klein Dalenstraat 42A**
**3020 Winksele (BE)**

(54) **Methods and systems for optimising immersion lithographic processing**

(57)     A method (300) is described for setting up immersion lithographic processing of a device (102). The immersion lithographic processing typically is characterised by immersion lithographic processing parameters. The immersion lithographic processing of a device (102) typically comprises contacting said device (102) with an immersion liquid (114) characterised by soak time related parameters. The method for setting up comprises obtaining (302) a value for at least one soak time related parameter based on said immersion lithographic processing parameters, deriving (304) an image performance characteristic for said immersion lithographic processing, using a model for at least one image performance parameter characteristic for said image performance characteristic as function of said at least one soak time related parameter and evaluating (306) said derived image performance characteristic with respect to a predetermined image performance characteristic criterion. If the derived image performance characteristic does not fulfil the image performance characteristic criterion, adjusting (308) said immersion lithographic processing parameters based on the derived image performance characteristic.

Fig. 3

**Description**

**Technical field of the invention**

The present invention relates to the field of lithographic processing of devices, e.g. in semiconductor processing. More particularly, the present invention relates to methods and devices for optimising immersion lithographic processing.

**Background of the invention**

In the production of today's integrated circuits, optical lithography is one of the key manufacturing techniques. In order to cope with the ongoing miniaturisation of integrated circuits or other devices and its associated problems, low $k_1$ solutions, i.e. solutions allowing high resolving power lithography, are often applied.

Control of critical dimensions (CD) and of the resist profile is increasingly important in low-$k_1$ lithography in order to guarantee the imaging quality for these solutions. This control is even more difficult in thin resist lithographic processing due to chemical interactions occurring at the resist surfaces. The critical dimension and resist profile control typically are affected by chemical interactions with the surface of the device and possibly with underlying layers of the device such as an anti-reflective coating. These chemical interactions may result in contamination, e.g. airborne contamination.

Implementation of immersion lithography further lays a burden on critical dimension and resist profile control since more sources of chemical interaction can play a role. For example, leaching of photo active material from the resist into the immersion liquid, or diffusion of the immersion liquid into the resist may occur. One solution to prevent possible contamination of and/or contamination by the immersion liquid is the use of a top coat. Nevertheless, whether a top coat is used or not, it is expected that critical dimension control and profile control in immersion lithography will be susceptible to more variations compared to dry lithography.

**Summary of the invention**

It is an object of the present invention to provide good apparatus or methods for improving immersion lithographic processing of devices. It is an advantage of embodiments of the present invention that they provide efficient methods and systems for optimizing immersion lithographic processing. It is an advantage of embodiments of the present invention that they allow optimization for a given immersion lithographic process without the need for studying the specific given immersion lithographic process in full. It is an advantage of embodiments of the present invention that optimization of immersion lithographic processes can at least partly be performed based on calculations rather than experimentally testing the specific immersion lithographic process.

The above objective is accomplished by a method and device according to the present invention.

The present invention relates to a method for setting up immersion lithographic processing of a device, said immersion lithographic processing being characterised by immersion lithographic processing parameters, said immersion lithographic processing of a device comprising contacting said device with an immersion liquid characterised by soak time related parameters, the method comprising, obtaining a value for at least one soak time related parameter based on said immersion lithographic processing parameters, and deriving an image performance characteristic for said immersion lithographic processing. In an aspect of the present invention a model for at least one image performance parameter, that is characteristic for said image performance characteristic, as function of said at least one soak time related parameter is used. This step compensates for, reduces the negative effect of, or optimises the effect of accumulated soak times, e.g. pre- and/or post-soak times, at each position on the device on the at least one image performance parameter. The method further comprises evaluating said derived image performance characteristic with respect to a predetermined image performance characteristic criterion; and if said derived image performance characteristic does not fulfil the image performance characteristic criterion, adjusting said immersion lithographic processing parameters based on the derived image performance characteristic. Said obtaining a value may be performed automated, e.g. by a processor. Said deriving an image performance characteristic may be performed automated, e.g. by a processor. Said evaluating may be performed automated, e.g. by a processor. Said adjusting may be performed automated, e.g. by a suitably programmed processor such as a microprocessor. It is an advantage of embodiments of the present invention that evaluation of immersion lithographic processing of a device may be performed without the need for experimental characterisation of the immersion lithographic processing. Said model may be a model based on a spatial distribution of soak time related parameters.

The model may be a model based on averaged soak time related parameter values and averaged image performance parameter values, averaged over predetermined image fields taking into account a scan direction of a printing scheme used for obtaining said at least one image performance parameter. The at least one soak time related parameters may comprise two independent soak time related parameters. The latter allows that the effects of pre-soak and post-soak are incorporated in the modelling.

The model may be a model based on image performance parameter values corrected for an average field fingerprint. The average field fingerprint may be a fingerprint related to scan-wise imaging dies on the device.

After the adjusting, said immersion lithographic processing parameters, the obtaining, deriving and evaluating step may be again performed.

The present invention also may relate to a method, e.g. automated method, for setting up immersion lithographic processing of a device, the immersion lithographic processing being characterised by immersion lithographic processing parameters, said immersion lithographic processing of a device comprising contacting said device with an immersion liquid characterised by soak time related parameters, the method comprising, receiving a value for at least one soak time related parameter based on said immersion lithographic processing parameters, automated calculating an image performance characteristic for said immersion lithographic processing, using a model for at least one image performance parameter, that is characteristic for said image performance characteristic, as function of said at least one soak time related parameter, automated evaluating the derived image performance characteristic with respect to a predetermined image performance characteristic criterion and, if said calculated image performance characteristic does not fulfil the image performance characteristic criterion, adjusting the immersion lithographic processing parameters in an automated way based on the derived image performance characteristic.

The present invention also relates to a method for setting up a model for an image performance characteristic for immersion lithographic processing of a device, the method comprising, selecting a calibration immersion lithographic process including a given printing scheme, determining at least one soak time related parameter for said calibration immersion lithographic process, quantifying, for said calibration immersion lithographic process, an image performance characteristic by determining image performance parameters, and building a model for said image performance characteristic of said immersion lithographic processing of a device based on deriving a relationship between said quantified image performance parameters and said determined at least one soak time related parameter for said calibration immersion lithographic process. Said selecting may be automated selecting, performed e.g. by a processor. Said determining at least one soak time related parameter may be automated determining, e.g. performed by a processor. Said quantifying an image performance characteristic may be an automated quantifying and said model building may be an automated model building, e.g. performed by a processor.

It is an advantage of the method for setting up a model that the model can be applied to all immersion lithographic processing of devices wherein the same resist processing and the same immersion liquid are used.

Said deriving a relationship between said quantified image performance parameters and said determined at least one soak related parameter is based on averaged soak time related parameter values and averaged image performance parameter values, averaged over predetermined image fields taking into account a scan direction of a printing scheme used for obtaining said at least one image performance parameter. The latter may be performed in an automated way. It is an advantage of the method for setting up a model that small soak time related image performance characteristics can be modelled.

The present invention also relates to a method for immersion lithographic processing of a device, the lithographic processing being determined by lithographic processing parameter values, said lithographic processing parameters being at least partly selected according to a method for setting up immersion lithographic processing of a device comprising, obtaining a value for at least one soak time related parameter based on said immersion lithographic processing parameters, deriving an image performance characteristic for said immersion lithographic processing, using a model for at least one image performance parameter, that is characteristic for said image performance characteristic, as function of said at least one soak time related parameter, evaluating said derived image performance characteristic with respect to a predetermined image performance characteristic criterion, and if said derived image performance characteristic does not fulfil the image performance characteristic criterion, adjusting said immersion lithographic processing parameters based on the derived image performance characteristic. The latter may be performed in an automated way. Said lithographic processing may comprise imaging a pattern on said device using a scan path and scan speed and using an exposure dose, wherein any of said scan path, said scan speed or said exposure dose are selected based on the method for setting up described above.

The present invention furthermore relates to a processing system, the system comprising an input means for receiving values for at least one soak time related parameter, a processing means for deriving an image performance characteristic for the immersion lithographic processing using a model for the image performance characteristic as function of the at least one soak time related parameter, an evaluation means for evaluating the derived image performance characteristic with respect to a predetermined image performance characteristic criterion, and an adjustment means for adjusting the immersion lithographic processing parameters based on the derived image performance characteristic, if said derived image performance characteristic does not fulfil the image performance characteristic criterion.

The present invention also relates to a computer program product for executing a method for setting up immersion lithographic processing of a device comprising, obtaining a value for at least one soak time related parameter based on said immersion lithographic processing parameters, deriving an image performance characteristic for said immersion lithographic processing, using a model for at least one image performance parameter, that is characteristic for said image performance characteristic, as function of said at least one soak time related parameter, evaluating said derived image performance characteristic with respect to a predetermined image performance characteristic criterion, and if said derived image performance characteristic does not fulfil the image performance characteristic criterion, adjusting said immersion lithographic processing parameters based on the derived image performance characteristic. Said lithographic processing may comprise imaging a pattern on said device using a scan path and scan speed and using an exposure dose, wherein any of said scan path, said scan speed or said exposure dose are selected based on the method for setting up described above. The invention furthermore relates to a machine readable data storage device storing such a computer program product or the transmission of such a computer program product over a local or wide area telecommunications network.

Particular and preferred aspects of the invention are set out in the accompanying independent and dependent claims. Features from the dependent claims may be combined with features of the independent claims and with features of other dependent claims as appropriate and not merely as explicitly set out in the claims.

The present concepts are believed to result in more efficient, stable and reliable immersion lithographic processing of devices and in improved devices made through immersion lithographic processing. The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 is a schematic representation of an illumination step during lithographic processing using an immersion lithography system, according to prior art.

Fig. 2 is a schematic representation of an immersion lithographic system, according to prior art.

Fig. 3 is a flow diagram of an example method for setting up an immersion lithographic process according to the first embodiment of the present invention.

Fig. 4 is a flow diagram of an example method for setting up a model for an image performance characteristic for immersion lithographic processing of a device according to the second embodiment of the present invention.

Fig. 5 illustrates parameters related to critical dimension of a feature as may be used as image performance parameters in embodiments of the present invention.

Fig. 6a and Fig. 6b is a schematic representation of a processing system (Fig. 6a) used for performing a method for setting up an immersion lithographic processing of a device and a computing system that may be adapted accordingly (Fig. 6b), according to a fourth embodiment of the present invention.

Fig. 7a to Fig. 7d illustrates a schematic view of an exposure sequence (Fig. 7a), a total soak time distribution (Fig. 7b), a pre-soak time distribution (Fig. 7c) and a post-soak time distribution (Fig. 7d) for immersion lithographic processing as may be used in embodiments of the present invention.

Fig. 8 illustrates an average intra-field soak-time fingerprint as function of the relative XY movements of the immersion showerhead and the device, as may be used in embodiments of the present invention.

Fig. 9 illustrates a post-soak time distribution for a wafer exposure using a smaller printing field compared to the distribution shown in Fig. 7d.

Fig. 10a and Fig. 10b illustrate CD parameter variations for the average intra-field (Fig. 10a) and the residual intra-field (Fig. 10b) for the different soak quadrants, resulting from applying a virtual immersion lithographic process illustrating advantages of embodiments according to the present invention.

Fig. 11a to Fig. 11c illustrate the full wafer print field as measured with an immersion lithographic system (Fig. 11a), the corresponding average field in the different soak quadrants (Fig. 11b) and a correlation graph between the average field in the different soak quadrants and the simulated post soak time results (Fig. 11c) for a device with a first top coating, illustrating advantages of embodiments according to the present invention.

Fig. 12a to Fig. 12b illustrate the a correlation graph between the average field in the different soak quadrants obtained using immersion lithographic processing and the simulated post soak time results for a device without top coating for the CD at the top surface of the resist (Fig. 12a) and for the resist thickness Fig. 12b, illustrating advantages of embodiments according to the present invention.

Fig. 13a to Fig. 13c illustrate the full wafer print field as measured with an immersion lithographic system (Fig. 13a), the corresponding average field in the different soak quadrants (Fig. 13b) and a correlation graph between the average field in the different soak quadrants and the simulated soak time results (Fig. 13c) for a device with a first top coating, illustrating advantages of embodiments according to the present invention.

Fig. 14a and Fig. 14b illustrate the post soak time distribution respectively total soak time distribution for a given immersion lithographic process, as may be used as input for a method according to the second embodiment of the present invention.

Fig. 15a to Fig. 18b illustrate the predicted CD at the top surface of the resist (Fig. 15a, Fig. 15b, Fig. 17a, Fig. 17b) and the predicted CD at the bottom surface of the resist (Fig. 16a, Fig. 16b, Fig. 18a, Fig. 18b) as function of process scan rate for a device with top coating layer (Fig. 15a, Fig. 15b, Fig. 16a, Fig. 16b) and for a device without top coating layer (Fig. 17a, Fig. 17b, Fig. 18a, Fig. 18b), as illustration of the first embodiment of the present invention.

In the different figures, the same reference signs refer to the same or analogous elements.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

The following terms are provided solely to aid in the understanding of the invention. These definitions should not be construed to have a scope less than understood by a person of ordinary skill in the art. With immersion lithography or immersion lithographic processing there is meant lithographic processing wherein an immersion liquid is used in between the device to be processed and a final element of the imaging system used for lithographic processing. The use of an immersion liquid allows capture of more light rays, compared with the situation where air is present between the final element of the imaging system and the device. In the present application, with dry lithography or dry lithographic processing, there is meant lithographic processing wherein no immersion liquid is present between the final element of the imaging system and the device, i.e. wherein typically air is present between the final element of the imaging system and the device. Typically in today's immersion lithography, the immersion liquid typically used is water, although the invention is not limited thereto.

The critical dimension (CD) typically is defined as the smallest width of a line or the smallest space between two lines that can be allowed in the manufacturing of a device for a given lithographic process.

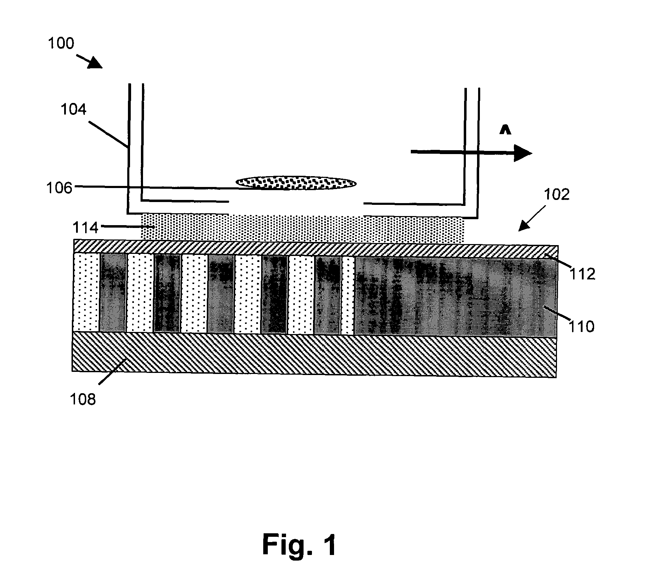

In the present invention, the term pre-exposure soak, also referred to as pre-soak will be used for referring to a contact between the immersion liquid and the device prior to illumination of the device. The term post-exposure soak, also referred to as post-soak will be used for referring to a contact between the immersion liquid and the device after the illumination of the device. By way of illustration, Fig. 1 shows the possibility for pre-soak and post-soak occurrence possibilities in part of an immersion lithographic set-up 100. Fig. 1 illustrates a schematic representation of part of an immersion lithographic set-up 100 for immersion lithographic processing of a device 102. The immersion lithographic set-up 100 typically comprises an immersion showerhead 104 and a final lens element 106 of the imaging system. The device 102 typically comprises a substrate 108 with a resist layer 110 and possibly a top coating layer 112. Between the device 102 and the immersion showerhead 104 typically an immersion liquid 114 is present. In Fig. 1 an immersion showerhead 104 moving relatively to the right with respect to the device 102 is shown. A region is shown wherein contact between the immersion liquid 114 and the device 102 occurs before illumination, i.e. a region with pre-soak , and a region is shown wherein contact between the immersion liquid 114 and the device 102 occurs after illumination of the device 102, i.e. a region with post-soak. In practice, during immersion lithographic processing, the contact of the immersion liquid 114 with the device 102, which can be referred to as a soak, typically is not uniform over the device, since the immersion liquid is locally kept in a small region, by the showerhead 104. During exposure of the device 102, the showerhead 104 is continuously in relative movement with the device 102, resulting in possible interaction time differences for different locations on the device 102. This relative movement is indicated in Fig. 1 by arrow A. The corresponding contact times, also referred to as pre-soak time and post-soak time, typically may vary between different places on a device e.g. due to the path of the immersion hood followed. Therefore, these may be referred to as local contact times.

Furthermore, the showerhead 104 area typically is larger than the exposed field area, determined by the slit of the lens 106. The latter implies that the device 102 will always be subject to a pre-soak. During this pre-soak, specific chemical interactions can occur, e.g. leaching of photo active compounds and quencher and/or diffusion of immersion liquid 114 or immersion liquid components in the resist layer 110. A top coating layer 112 should be a barrier for this behaviour, but some molecules may still be able to diffuse through the top coating layer 112. During exposure, the photochemical reaction generates new products in the resist layer 110, made of photoresist material, which in turn can diffuse or react with the immersion liquid 114. After exposure, a considerable soak, i.e. post-soak, may occur as the immersion showerhead 104 is larger than the exposure field. During post-soak e.g. chemical interaction may occur with the acid generated after exposure. Furthermore soak also may occur when e.g. neighbouring dies are exposed. These considerations, illustrated in Fig. 1, suggest that a lot of variables are involved, which all could lead to changes in image performance characteristics, such as resist profile changes and/or CD-variations. Moreover, the chemical interaction mechanism can be very complex and material specific, so it can be hard to predict quantitatively how much impact the soak will have towards CD-control, during printing on an immersion scanner.

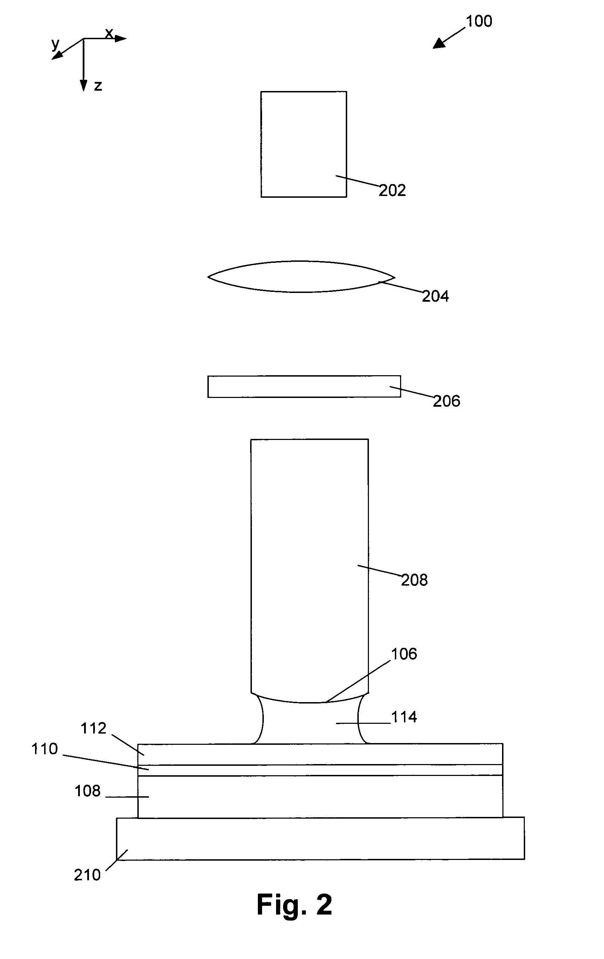

The embodiments of the present invention typically may be related to an immersion lithographic processing system. The method is applicable to lithographic processing which can be performed on any type of immersion lithographic set-up, such as but not limited to the set-up shown in Fig. 2, shown by way of illustration only. An optical lithographic system with a transmission set-up is shown, although the invention is not limited thereto and is e.g. also applicable to a system with a reflection set-up. It may be e.g. an immersion lithographic stepper system or an immersion lithographic scanner system. The optical immersion lithographic system 100 typically comprises a source of electromagnetic radiation, e.g. a light source 202. The light from the light source 202 typically is transmitted through an optical system 204 comprising a lens and is incident on a mask 206. The mask 206 contains information about the image to be generated in a resist layer and is basically defined thereby. Typically the mask 206 may be part of a set of masks used for creating a device or circuit using lithography. Different types of masks exist; such as e.g. an alternated phase shift mask, an attenuated phase shift mask, a binary mask, etc. The light, carrying the mask information, is then passed through an imaging module 208, which e.g. may have a final lens surface 106, and thus is guided to a resist layer 110 on a substrate 108. The optics of the imaging module 208 inherently defines the numerical aperture (N.A.) of the imaging module 208. The device 102 typically is mounted on a substrate stage 210. Typically an immersion showerhead 104 provides an immersion liquid 114 between the resist layer 110 and the output of the imaging module 208, e.g. the final lens surface 106, in order to allow increase of the numerical aperture of the system 100. A typical immersion liquid 118 used is water. Other optional and/or additional components are not illustrated in Fig. 2.

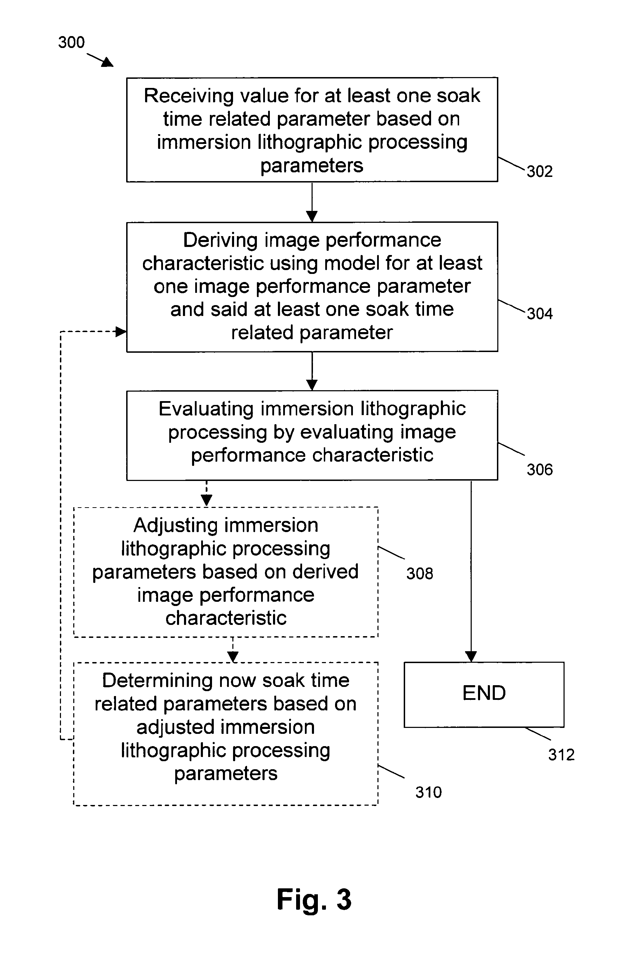

In a first embodiment, the present invention relates to a method for setting up immersion lithographic processing of a device 102. In immersion lithographic processing, typically an immersion liquid 114 is used in between the last optical element of the imaging module and the surface of the device 102 in order to increase the numeral aperture of the system 100. Immersion lithographic processing typically is characterised by a set of immersion lithographic processing parameters, such as a layout of a pattern to be imaged on a device, the scanning path followed to image a pattern on a device, the scan speed, the dimensional properties of the lithographic system used, the optical setting used such as for example exposure time and coherence of the light used, the immersion liquid selected, the resist and its corresponding processing selected, etc. It is an advantage of the method for setting up immersion lithographic processing of a device according to the present embodiment that adjusting of parameter values of the immersion lithographic processing parameters may be performed such that negative image performance effects due to a contact between the immersion liquid 114 and the device 102, i.e. a soak, are minimised. The latter may be performed in combination with other optimisation methods. The method according to the first embodiment of the present invention comprises obtaining a value for at least one soak time related parameter, determined by said immersion lithographic processing parameters, such as e.g. the scanning path followed, the immersion liquid selected, the resist selected, the scan speed and dimensional properties of the immersion showerhead 104. The method also comprises deriving an image performance characteristic for the immersion lithographic processing characterised by at least one image performance parameter. The latter is performed using a model for the at least one image performance parameter as function of the at least one soak time related parameter. Based on the derived image performance characteristic, adjustment of the immersion lithographic processing parameters may be performed. The different steps may and/or the combination thereof may be performed in an automated way. By way of illustration, the invention not being limited thereto, necessary and optional steps for the method 300 for setting up immersion lithographic processing of a device according to the first embodiment of the present invention will be discussed in more detail below, with reference to Fig. 3.

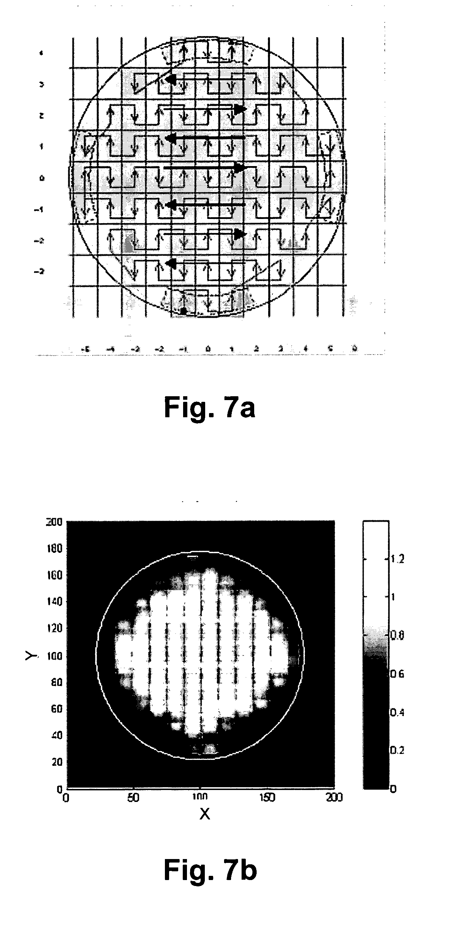

In a first step 302, the method comprises receiving a value for at least one soak time related parameter determined by the immersion lithographic processing parameters characterising the immersion lithographic process under study. Typically, the at least one soak time related parameter obtained comprises a set of values for at least one soak time related parameter for different locations on the device, i.e. a spatial distribution over the device of the at least one soak time related parameter is present. The at least one soak time related parameter typically may comprise a pre-soak time, a post-soak time, an exposure soak time and a total soak time. The pre-soak time and the post-soak time typically are dominant over the exposure soak time, as the exposure soak time typically is shorter and furthermore it typically is constant over the device area, i.e. not depending on the path. Consequently - although the invention is not limited thereto, for ease of illustration the exposure soak time is neglected. The total soak time then is the sum of the pre-soak time and the post-soak time, thus typically the at least one soak time related parameter may comprise two independent parameters, e.g. the post-soak time and the total soak time, while the pre soak time can be derived therefrom. Receiving a value for at least one soak time related parameter may be receiving it from an external source or may comprise calculating it. Typically, soak time related parameters may be calculated taking into account parameters of the immersion lithographic processing under study, i.e. the scan direction, the scan speed, dimensional characteristics of the immersion head, etc. Such calculation may be performed in an automated way, e.g. using dedicated software. An example of a calculation of pre-soak time, post-soak time and total soak time for a given process path will be provided further in the text, with respect to Fig. 7a to Fig. 9 and its corresponding description.

In a second step 304, the method comprises deriving an image performance characteristic using a model for at least one image performance characteristic and the at least one soak time related parameter. Such a model typically may be a model obtained by correlating CD information with soak time related parameters. Typically two independent soak time related parameters are used, allowing to separate pre-soak from post-soak. Different types of models may be used, such as analytical models, empirical models, models based on neural networks, etc. The model may be a linear model, an exponential model, ... as described in more detail in the second embodiment but also applicable for the present embodiment. The image performance characteristic that may be derived using the model may e.g. be a critical dimension, a critical dimension related parameter and/or a resist profile related parameter. Deriving an image performance characteristic may be performed in an automated way.

In a third step 306, the method comprises evaluating the derived image performance characteristic thus evaluating the immersion lithographic processing under study. Such evaluation may comprise determining whether an obtained image performance characteristic, e.g. a critical dimension or parameter related thereto, is below or above a predetermined limit value and thus deriving whether the immersion lithographic process is allowable. The latter may e.g. comprise evaluating whether the print quality that will be obtained will be sufficient for the print one wants to make, e.g. if the obtainable CD is small enough. The latter may be performed in an automated way, whereby e.g. an algorithm may be used.

In an optional fourth step 308, the obtained image performance characteristic results may be used for adjusting the immersion lithographic processing parameters. For example, based on the above results, the optical setting of the immersion lithographic processing may be altered for changing the exposure dose, thus resulting in an adjustment of the image performance characteristic, such as e.g. the obtained critical dimension. Such adjustments may e.g. be performed using Dose-mapper as available from ASML. Other parameters that may be altered are e.g. the process path followed for imaging on the device. In other words, the route followed for imaging on the device may be altered such that the soak time related parameters are altered and consequently also the image performance parameters are altered.

In a further optional step 310, when e.g. the lithographic processing parameters are adapted such that the soak times occurring in the immersion lithographic processing are altered, the new soak times related parameters may be calculated and further refinement of the optical parameters may be performed. The latter may be continued until a predetermined level of image performance parameter is obtained. When no substantial adjustments are made to lithographic processing parameters influencing soak times, the method may end in an end step 312, after third step 306.

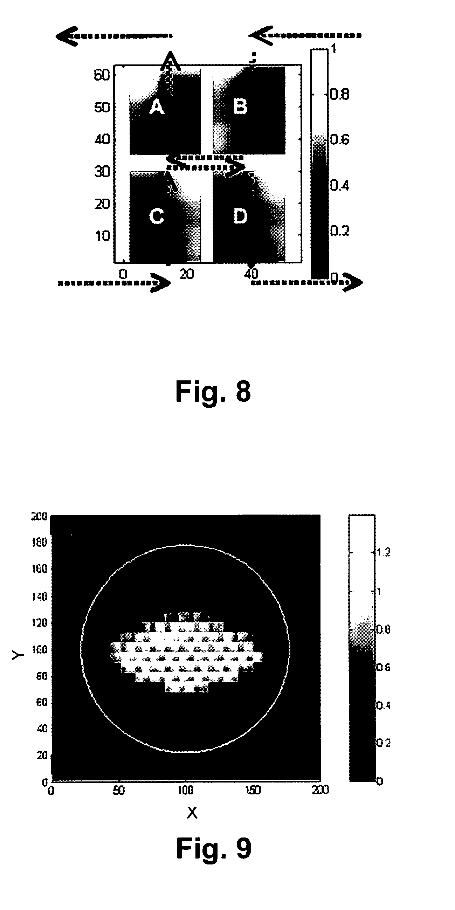

In a preferred embodiment, the model used for determining an image performance characteristic of the immersion lithographic processing to be set-up takes into account a statistical data analysis of the obtained image performance parameter data and of the soak time related parameters. The latter allows to better reveal the small effects of soak time related parameter variations on the image performance parameter. The model may be based on removing an average intra-field fingerprint in the image performance parameter data, i.e. removing an image performance parameter fingerprint relating to amongst others the reticle. If the latter is performed, an average field component also needs to be removed from the soak time related parameter calculations. Alternatively, or more preferably in combination therewith, the model also may be based on averaging the image performance parameter over predetermined fields, whereby those predetermined fields are selected that were imaged using the same relative movement of the immersion showerhead. The latter results in four different averaged fields for the image performance parameter(s). If the latter is performed, averaging of soak-time related parameters fields with respect to predetermined soak-time related parameter fields obtained using the same relative movement of the immersion showerhead also is performed, resulting in four different averaged fields for the soak time related parameter(s). Performing the above described statistical data analysis of the soak-time related parameter(s) and the image performance parameter(s) allows more easily revealing of soak-time related image performance variations. An example of such a statistical data analysis of the soak time related parameter(s) and the image performance parameter(s) for a given process path is provided further in the text, with respect to Fig. 8 and Fig. 10a to Fig. 13c and its corresponding description.

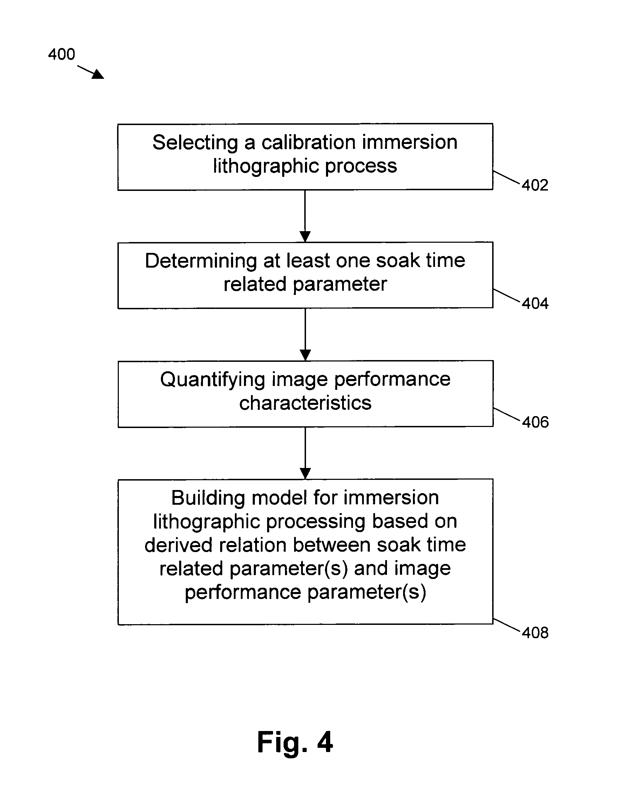

In a second embodiment, the present invention relates to setting up of a model for immersion lithographic processing. The method for setting up a model typically comprises selecting a calibration immersion lithographic process, which will be used for obtaining initial data on which the model is based. The method also comprises determining at least one soak related parameter for the given calibration immersion lithographic process and quantifying an image performance characteristic by determining image performance parameters for the given calibration immersion lithographic process. The method finally comprises building a model for the image performance characteristic of the immersion lithographic processing of a device based on deriving a relationship between the quantified image performance characteristic and the determined at least one soak time related parameter for the calibration immersion lithographic process. Different types of models may be used, such as analytical models, empirical models, models based on neural networks, etc. By way of illustration, the invention not being limited thereto, necessary and optional steps for the method 200 for setting up a model for image performance characteristics in immersion lithographic processing according to the embodiment of the present invention will be discussed in more detail below, with reference to Fig. 4.

In a first step 402, a calibration immersion lithographic process is selected. By selecting a calibration immersion lithographic process, the process for which initial measurements will be made is selected. Such a selection typically may be based on an available experimental set-up. Selecting a calibration immersion lithographic process may comprise selecting a field size for imaging a pattern on a device, a route sequence i.e. processing path followed for imaging a pattern on a device, selecting a scanning speed, and also may comprise selecting other lithographic processing parameters which define the specific features of the calibration immersion lithographic process that will be performed, such as e.g. the immersion liquid used, the resist used, whether or not a topcoat is used, etc. As the exposure of any layout typically will result in variations of soak time related parameters, the specific layout is not limiting for the present invention. Preferably, a layout is selected resulting in a sufficient range in soak time related parameters, e.g. after averaging of the soak time for different exposure fields. E.g. in a model that will use two independent soak time related parameters such as e.g. the post-soak time $t_{post\text{-}soak}$ and total soak time $t_{total\ soak}$ a layout may be used wherein a sufficient range in these time parameters is present. The selecting step may be performed in an automated way. In an example of an automated method, instead of a selecting step, receiving parameters defining a calibration immersion lithographic processing may be performed.

In a second step 404, determining at least one soak time related parameter for the calibration immersion lithographic process is performed. Typically, the at least one soak time related parameter is determined for different locations on the device, i.e. the spatial distribution over the device of the at least one soak time related parameter is determined. Image performance characteristics may be influenced by different soak time related parameters as they can be due to different mechanisms, some correlated with total soak time, some correlated with pre-soak time, some correlated with post-soak time. Consequently, the at least one soak time related parameter typically may comprise any of pre-soak time, post-soak time or total soak time. As the total soak time is the sum of the pre-soak time and the post-soak time, typically the at least one soak time related parameter may comprise two independent parameters, e.g. the post-soak time and the total soak time. Such a calculation typically takes into account the scan direction, the scan speed, dimensional characteristics of the immersion head, etc. In order to determine soak time related parameters, dedicated software may be used calculating the time a device is in contact with the immersion liquid based on a process path, a scan speed and a diameter of the contact area between the immersion liquid and the device during the illumination step. An example of a calculation of pre-soak time, post-soak time and total soak time for a given process path will be provided further in the text, with respect to Fig. 7a to Fig. 9 and its corresponding description. The determining step may, in an example of an automated method, comprise calculating an at least one soak time related parameter using a processor.

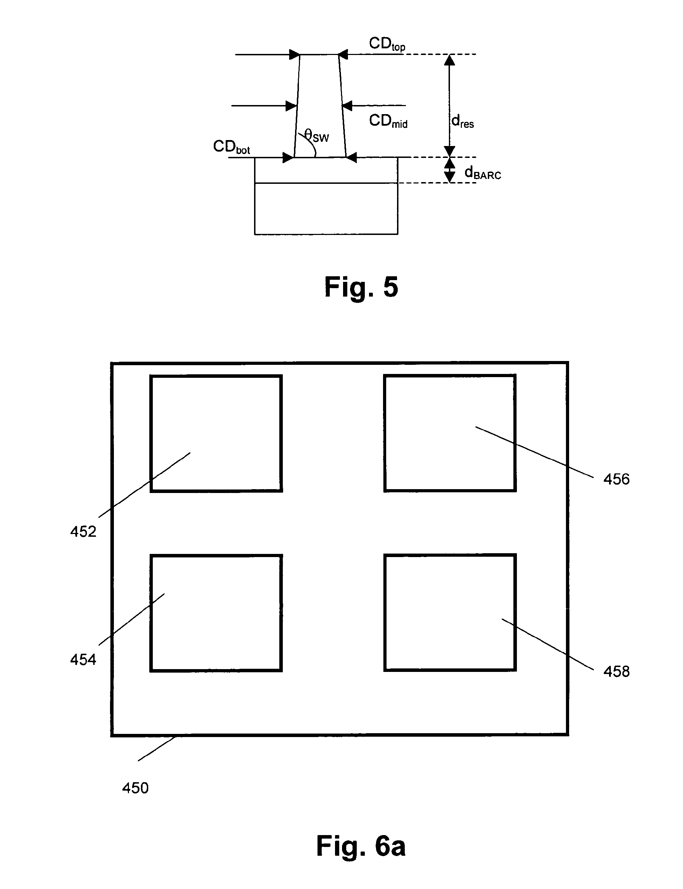

In a third step 406, quantification of the image performance characteristic may be performed by determining image performance parameters. The latter may be performed in any suitable way, such as e.g. using scatterometry evaluation, using CD-scanning electron microscopy, or using cross-section scanning electron microscopy. Scatterometry evaluation of immersion exposed wafers may for example be done using multiple parameters of critical dimensional control. Typical image performance parameters that may for example be used are illustrated in Fig. 5, indicating the following parameters : critical dimension at the surface of the resist $CD_{top}$, critical dimension at the bottom of the resist $CD_{bot}$, critical dimension at half the resist height $CD_{mid}$, resist thickness $d_{resist}$, bottom anti-reflective coating thickness $d_{BARC}$ and side wall angle $\theta_{side\ wall}$. The latter are based on a simple trapezoidal model. Quantifying may be performed in an automated way, e.g. using a processor and/or a measurement system.

In a fourth step 408, a model is build for the image performance characteristic of the immersion lithographic processing of a device based on deriving a relationship between the quantified image performance characteristics and the determined at least one soak time related parameter, as obtained in steps 404 and 406. In other words, the relationship

$$[\ image\ performance\ parameter(s)\ ]\ = f(t_{pre\text{-}soak}, t_{post\text{-}soak}, t_{total\ soak}) \qquad\qquad [1]$$

may be determined, whereby the image performance parameter typically may for example be a parameter related to the critical dimension of the obtained structure, $t_{pre\text{-}soak}$ is the pre-soak time, $t_{post\text{-}soak}$ is the post-soak time and $t_{total\ soak}$

is the total soak time.. In other words, a modelling is performed by correlating the measurement data for the calibration device with the soak time data. The latter may be performed in an automated way.

In the following, a few examples of models are shown by way of illustration, the invention not being limited by the specific choice of model. The choice of model will typically depend on the underlying chemical and/or physical cause of the critical dimension variation. When the variation in soak time is small, a linear model may be sufficient. As mentioned above, typically using two of $t_{pre-soak}$, $t_{pos-soak}$ and $t_{total\ soak}$ may be sufficient as these three soak times are related.

In a first example model, for a particular scan speed, a linear approximation typically may be used. A linear correlation between the soak time results and the measurement data can be found. The model then is determined by e.g.

$$[\text{ image performance parameter(s) }] = A. \, t_{post-soak} + B. \qquad [2]$$

Parameters A and B are determined based on fitting the soak time and image performance parameter data. A linear model nevertheless does not allow to accurately model a situation for different scan speeds. Furthermore, although good experimental results are obtained, a linear model is not appropriate over the range of soaking times, i.e. interaction times. Therefore, other models may be used.

In a second example, an exponential model is used. The latter can e.g. be justified as water diffusion can play a root cause. The model then is determined by

$$[\text{ image performance parameter(s) }] = a + b.\exp(-c.t_{post-soak}) + d.\exp(-f.t_{total\ soak})$$

$$[3]$$

whereby all parameters a, b, c, d, f are fitted according to image performance parameter(s) and soak time related parameter(s) data.

In a third example, a model based on post soak time and total soak time is provided for two specific CD parameters in a two dimensional model for imaged structure, i.e. the critical dimension at the bottom surface of the resist is given by

$$CD_{bot} = a_B + b_B. \, \exp(-t_{post-soak}/\tau_{post,\ B}) + b_B.\exp(-t_{total\ soak}/\tau_{tot,\ B}) \qquad [4]$$

and the critical dimension at the top surface of the resist is given by

$$CD_{top} = a_T + b_T. \, \exp(-t_{post-soak}/\tau_{post,\ T}) + b_T.\exp(-t_{total\ soak}/\tau_{tot,\ T}) \qquad [5]$$

with $\tau_{post,\ B}$, $\tau_{tot,\ B}$, $\tau_{post,\ T}$ and $\tau_{tot,\ T}$ different time constants and whereby all parameters $a_B$, $b_B$, $a_T$, $b_T$ are fitted according to image performance parameter(s) and soak time related parameter(s) data.

It is an advantage of embodiments of the present invention that the model for image performance characteristics can be used for immersion lithographic processing with other immersion conditions, such as e.g. any immersion lithographic processing using the same resist process. In other words, the model for the image performance characteristic(s) may be used for immersion lithographic processing wherein substantially the same chemical and/or physical interactions occur between the immersion liquid and the top surface of the device.

In a preferred embodiment, the model to be set-up takes into account a statistical data analysis of the obtained image performance parameter data and of the soak time related parameters. The latter allows to better reveal the small effects of soak time related parameter variations on the image performance parameter. The model may be based on removing an average intra-field fingerprint in the image performance parameter data, i.e. removing an image performance parameter fingerprint relating to amongst others the reticle. If the latter is performed, an average field component also needs to be removed from the soak time related parameter calculations. Alternatively, or more preferably in combination therewith, the model also may be based on averaging the image performance parameter over predetermined fields, whereby those predetermined fields are selected that were imaged using the same relative movement of the immersion showerhead. The latter results in four different averaged fields for the image performance parameter(s). If the latter is performed, averaging of soak-time related parameters fields with respect to predetermined soak-time related parameter fields obtained using the same relative movement of the immersion showerhead also is performed, resulting in four different averaged fields for the soak time related parameter(s). Performing the above described statistical data analysis of the soak-time related parameter(s) and the image performance parameter(s) allows more easily revealing of soak-time related image performance variations. An example of such a statistical data analysis of the soak time related parameter(s) and the image performance parameter(s) for a given process path is provided further in the text, with respect to Fig. 8 and Fig. 10a to Fig. 13c and its corresponding description.

In a third embodiment, the present invention relates to a method for immersion lithographic processing of a device. The method for immersion lithographic processing comprises an illumination step and typical other lithographic processing steps known from prior art. In the present embodiment, the immersion lithographic processing, determined by immersion lithographic processing parameters, is characterised in that it is performed using immersion lithographic processing parameters selected determined using a method for setting up immersion lithographic processing of a device as described in the first embodiment of the present invention. In other words, the immersion lithographic processing is evaluated and possible adjusted by obtaining a value for at least one soak time related parameter based on the immersion lithographic processing parameters determining the immersion lithographic processing, deriving an image performance characteristic using a model for the at least one image performance parameter characteristic for the image performance characteristic as function of the at least one soak time related parameter and evaluating the obtained image performance characteristic. Depending on the evaluation of the image performance characteristic, the immersion lithographic processing parameters may be adjusted. Typical parameters that may be adjusted are any of the exposure dose, the scan speed, the scan path followed during imaging, the resist selected or the immersion liquid selected. The immersion lithographic processing of the present embodiment thus is the result of an optimisation procedure performed using a method according to the first embodiment of the present invention. The method for immersion lithographic processing of a device may lead to improved lithographic processing, resulting in a higher quality of the obtained printed image. The method may be performed in an automated way.

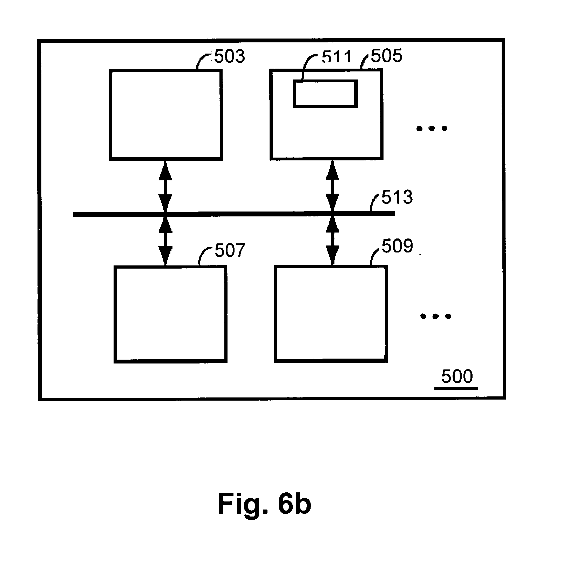

In a fourth embodiment, the present invention relates to a processing system wherein the method embodiments according to the present invention are implemented. In other words, it relates to a processing system 450 adapted for performing a method for setting up an immersion lithographic process, the system comprising an input means 452 for receiving values for at least one soak time related parameter, a processing means 454 for deriving an image performance characteristic for the immersion lithographic processing using a model for the image performance characteristic as function of the at least one soak time related parameter and an evaluation means 456 for evaluating the derived image performance characteristic for the immersion lithographic processing. The system furthermore comprises an adjustment means 458 for adjusting immersion lithographic processing parameters depending on the evaluation of the derived image performance characteristic. The input means 454 also may be adapted for receiving immersion lithographic processing parameters for characterising the immersion lithographic processing system to be set-up. Such a system may be a processing system 500, such as the processing system shown by way of example in Fig. 6b. Fig. 6b shows one configuration of processing system 500 that includes at least one programmable processor 503 coupled to a memory subsystem 505 that includes at least one form of memory, e.g., RAM, ROM, and so forth. A storage subsystem 507 may be included that has at least one disk drive and/or CD-ROM drive and/or DVD drive. In some implementations, a display system, a keyboard, and a pointing device may be included as part of a user interface subsystem 509 to provide for a user to manually input information. Ports for inputting and outputting data also may be included. More elements such as network connections, interfaces to various devices, and so forth, may be included, but are not illustrated in Fig. 6b. The various elements of the processing system 500 may be coupled in various ways, including via a bus subsystem 513 shown in Fig. 6b for simplicity as a single bus, but will be understood to those in the art to include a system of at least one bus. The memory of the memory subsystem 505 may at some time hold part or all (in either case shown as 511) of a set of instructions that when executed on the processing system 500 implement the step(s) of the method embodiments described herein. Thus, while a processing system 500 such as shown in Fig. 6b is prior art, a system that includes the instructions to implement aspects of the present invention is not prior art, and therefore Fig. 6b is not labelled as

prior art.

It is to be noted that the processor 503 or processors may be a general purpose, or a special purpose processor, and may be for inclusion in a device, e.g., a chip that has other components that perform other functions. Thus, one or more aspects of the present invention can be implemented in digital electronic circuitry, or in computer hardware, firmware, software, or in combinations of them. Furthermore, aspects of the invention can be implemented in a computer program product tangibly embodied in a carrier medium carrying machine-readable code for execution by a programmable processor. Method steps of aspects of the invention may be performed by a programmable processor executing instructions to perform functions of those aspects of the invention, e.g., by operating on input data and generating output data. Accordingly, the present invention includes a computer program product which provides the functionality of any of the methods according to the present invention when executed on a computing device. Further, the present invention includes a data carrier such as for example a DVD, CD-ROM or a diskette which stores the computer product in a machine-readable form and which executes at least one of the methods of the invention when executed on a computing device. Nowadays, such software is often offered on the Internet or a company Intranet for download, hence the present invention includes transmitting the computer product according to the present invention over a local or wide area network.

The advantages of some methods and systems according to the present invention will be further illustrated by way of examples. It is to be noticed that the methods and systems of the present invention are not limited thereto.

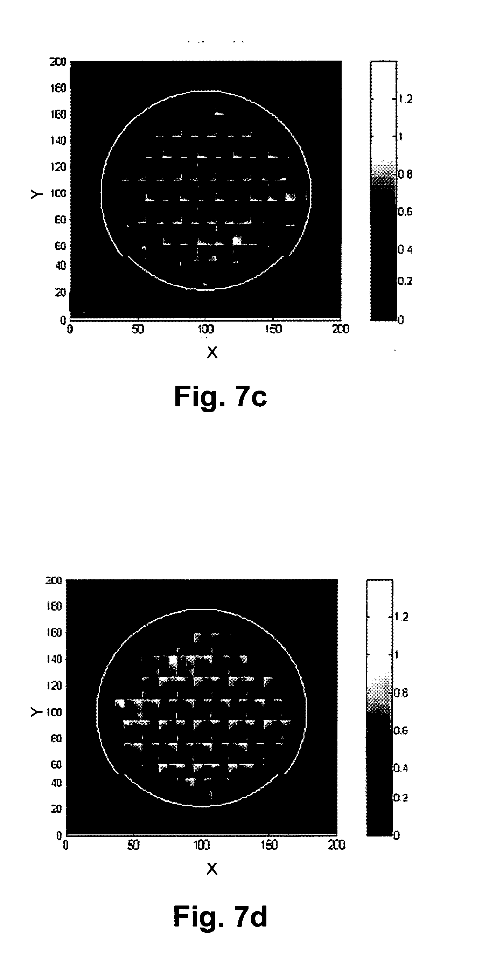

In a first example, soak time variations over a device for a given scanner exposure step are illustrated, showing the presence of different pre-soak and post-soak time behaviour over a device during immersion lithographic processing, which may be taken into account in embodiments of the present invention. An illustration is provided of the exposure sequence and the resulting total soak time distribution, the pre-soak time distribution and the post-soak time distribution for a plurality of fields to be printed. In Fig. 7a to Fig. 7d, the example of an exposure of 71 fields of 26mm by 33mm size on a 300mm wafer is illustrated. Fig. 7a shows a possible exposure sequence, in the present example being a default exposure sequence of a Twinscan ASML scanner as obtainable from ASML Corporation. It can be seen that in the present example the printing typically is performed row per row, starting from the lower left position and alternating the scanning directions for the subsequent exposures. During the exposure described in the present example, the stage typically moves at a constant velocity with respect to the showerhead. In between the exposures, the stage makes a U turn, thus providing relative variations in X-velocity and Y-velocity for the showerhead of the lithographic system. The soak time calculations are determined based on the provided exposure sequence and the velocity during exposure, typically selected as function of the required exposure dose, and dimensional properties of the showerhead, e.g. the showerhead diameter. Fig. 7b shows the calculated total soak time for an exposure with an exposure path as shown in Fig. 7a. Variations of the total soak time can be seen, with an average soak time for the central part of the device of about 1.1s. For edge dies the soak time is less, since the showerhead is passing less over that region, as less neighbouring dies are present. As the chemical interactions in pre-soak can be different to those in post-soak, the distribution of pre- and post-soak are visualized separately in Fig. 7c respectively Fig. 7d, corresponding again to the exposure path shown in Fig. 7a. It can be seen that in the interior of the wafer, the soak time shows a larger intra-field fingerprint, which can be different from field to field. While the overall total soak time was about 1.1 s, for pre- and post-soak the intra-field soak times vary in between 0.2s to 0.8s, which is a significant variation. For edge dies a lower pre-soak time and post-soak time can be seen compared to centrally positioned dies, whereby the discrepancy in soak time is mainly present on edge dies in the lower substrate half for the pre-soak case, while the edge dies in the upper wafer half are more affected for the post-soak case. The latter illustrates that different soak times typically occur over the device and even within an exposure field of a scanner system. The latter can be explained by the particular relative XY movements between the substrate and the showerhead, which can be different from field to field. This is illustrated in Fig. 8 where, as an example, the post-soak time for interior dies is averaged in four groups according to the scan direction of that field and according to the overall direction the showerhead is moving when it is exposing a row in the device layout. This again confirms the significant intra-field variation of the post-soak time. It can be seen that the extreme intra-field soak time and the signature are clearly field dependent, due to the differences in X-Y movements. This indicates that for interior fields variation, the interaction can be described using the four characteristic soak quadrants shown in Fig. 8. Applying the same printing sequence for a printing field of about half the size results in a significant impact on the soak time distribution over the device, as can be seen in Fig. 9. It can be seen that the maximum post-soak time is now increased to the order of 2s. Since the edge dies of the upper wafer half still have post-soak times in the order of 0.3s, across wafer soak time variation will certainly increase for smaller printing fields, but most of this increase will be present in the device edge region. The characteristic intra-field soak fingerprint is still present but its shape is modified due to the relative changes in exposure movements. For post-soak, time variations of about 0.5s can be seen. For interior dies, the magnitude of the intra-field soak time variations seems comparable to these of the full field case and the main effect is an over-all higher average value. From these experiments it can be seen that the soak of the wafer in an immersion scanner is local, i.e. defined by the showerhead area and dynamic, since continuously the wafer is in movement relative to the lens for exposing the different fields on a wafer. Due to this local and dynamic behavior, during the printing of fields on a wafer, some parts of the device will have more interaction time (i.e. more soak), than others. As suggested also previously, other physical or chemical interactions might occur either before or after exposure. Therefore, taking into account both pre-soak and post-soak and adjusting the immersion lithographic process to prevent the corresponding image performance effects may be advantageous.

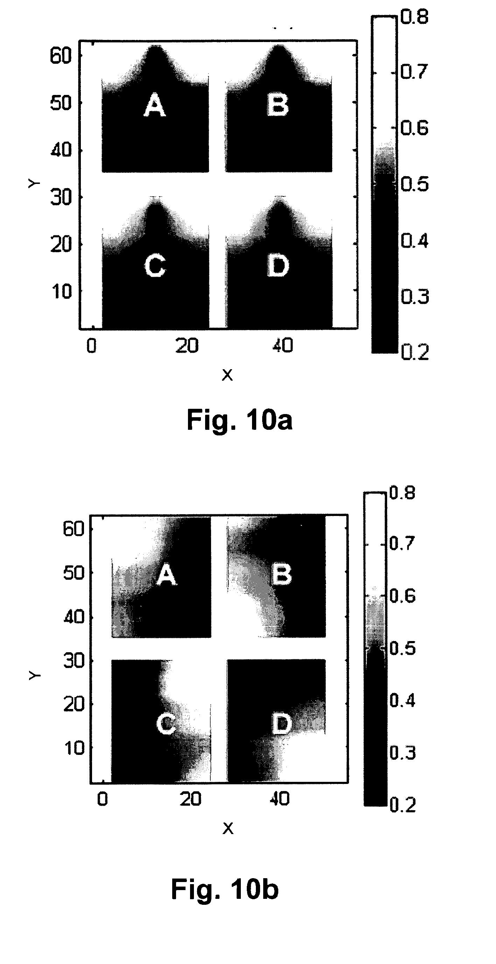

The second example shows an illustration of how a relation between an image performance parameter of an immersion lithographic process and soak time related parameters as shown in Fig. 7b to Fig. 7d. The results are obtained for a standard resist for advanced 193nm gate technology, i.e. PAR 817. Devices comprising a resist layer of 150nm on a standard bottom anti-reflective coating (BARC) and with or without commercial top coating layer that is developer soluble are tested. The target structure is a 90nm dense (1:1 line/space) grating and a reticle of 12 x 15 gratings with a 26mm x 33mm exposure field is used. Exposure is done using a binary reticle in combination with 0.75NA and $\sigma_i/\sigma_0$=0.89/0.59 annular settings. The processing path as illustrated in Fig. 7a is followed. Scatterometry is chosen to characterize CD-variations as image performance characteristic, using both a KLA-Tencor F5 system and a TEL iODP system. The critical dimension analysis was performed on averaged fields having the same relative movement of showerhead with respect to the wafer, as also discussed for Fig. 8, to reveal the CD-variations related to soak only. The average intra-field CD-fingerprint therefore was subtracted from the raw data to obtain the characteristic quadrants of the experimental CDU devices. The latter was also applied to the results of the simulated soak time related parameters. In order to remove the common intra-field component from the characteristic quadrants shown in Fig. 8, the field specific soak time is decomposed in an average intra-field component and a remaining intra-field residual, which is soak quadrant specific, as shown in Fig. 10a and Fig. 10b respectively. It is the soak time residual shown in Fig. 10b that is compared with the data obtained in the real immersion lithographic process.

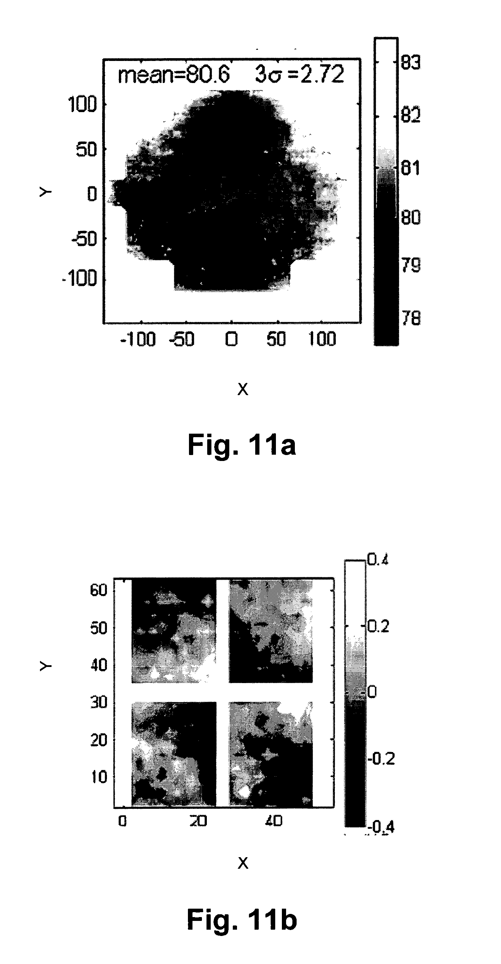

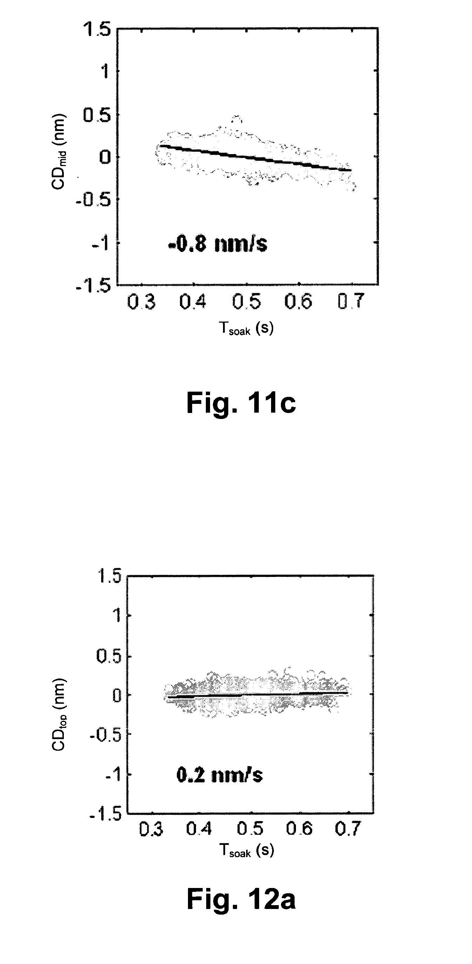

CD uniformity measured on an immersion lithography system for a device having a resist with a top coat as described above are shown in Fig. 11a to Fig. 11c. Fig. 11a illustrates raw data of full wafer uniformity of the critical dimension at half the resist height wherein the average intra-field fingerprint is removed. Nevertheless, no clear soak related fingerprint can be seen. When averaged towards the characteristic soak quadrants, a soak related impact can be seen as shown in Fig. 11b. Correlating the obtained results of Fig. 11b with the simulated soak time results shown in Fig. 10b illustrates that a weak impact is present, as shown in the correlation plot shown in Fig. 11c. The sensitivity of the critical dimension at half resist height parameter to soak time calculated from this plot was -0.8nm/s.

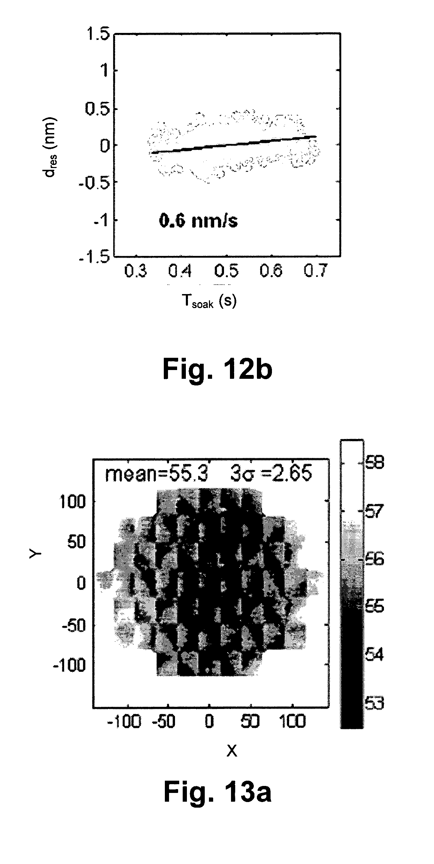

CD uniformity results measured on an immersion lithography system, for a device having a resist but without top coat as described above are shown in Fig. 12a to Fig. 12b. The full wafer uniformity raw data (not shown) corrected for the average intra-field fingerprint do not indicate a soak related fingerprint but averaging the data towards the characteristic soak quadrants and correlating this data with simulated soak time distributions reveals a soak related effect as can be seen in Fig. 12a for the critical dimension at the top side of the resist and in Fig. 12b for the resist thickness parameter. The correlation plot of Fig. 12a shows that the sensitivity of the CD at the top side of the resist parameter to soak time (0.2nm/s) is lower than for a device with top coating and that its sign is opposite.

The latter illustrates that a correlation can be obtained between the soak time related parameters and image performance parameters of an immersion lithographic process.

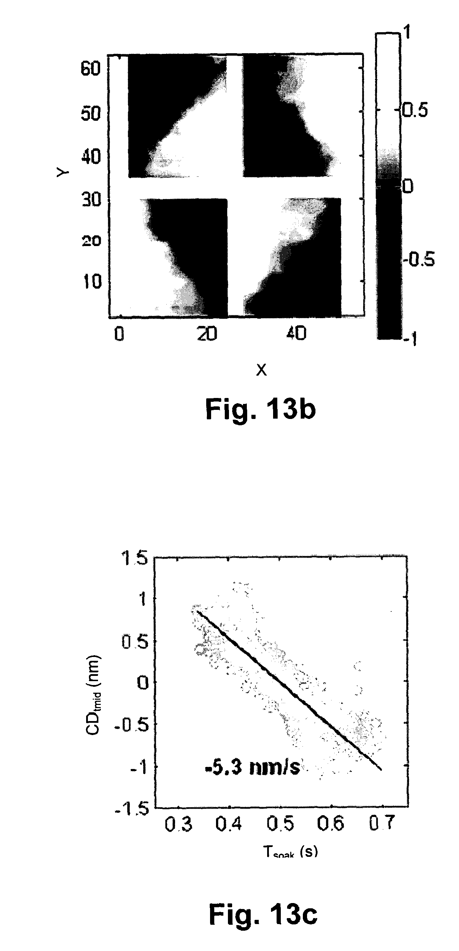

In a third example, results are shown for immersion lithographic processing of a device with a resist layer and another type of top coating. Results are obtained using the same illumination settings and reticle as described in the previous example. It reveals a soak related fingerprint on the device, after the intra-field average was removed. This is illustrated in Fig. 13a to Fig. 13c, whereby in Fig. 13a the full wafer uniformity is shown for the obtained CD at half the height of the resist layer, giving a similar across-wafer behavior as the post-soak time distribution as shown in Fig. 7d. When the CD at half the height of the resist layer is averaged according to their characteristic soak quadrants, then the effect is becoming even more apparent, as is illustrated in Fig. 13b. Moreover, in Fig. 13c this soak quadrant data is put in a correlation plot resulting in a value for CD-response - around 5nm/s. The latter illustrates a soak related CD variation and illustrates the validity of the soak time simulation illustrated in the first example.

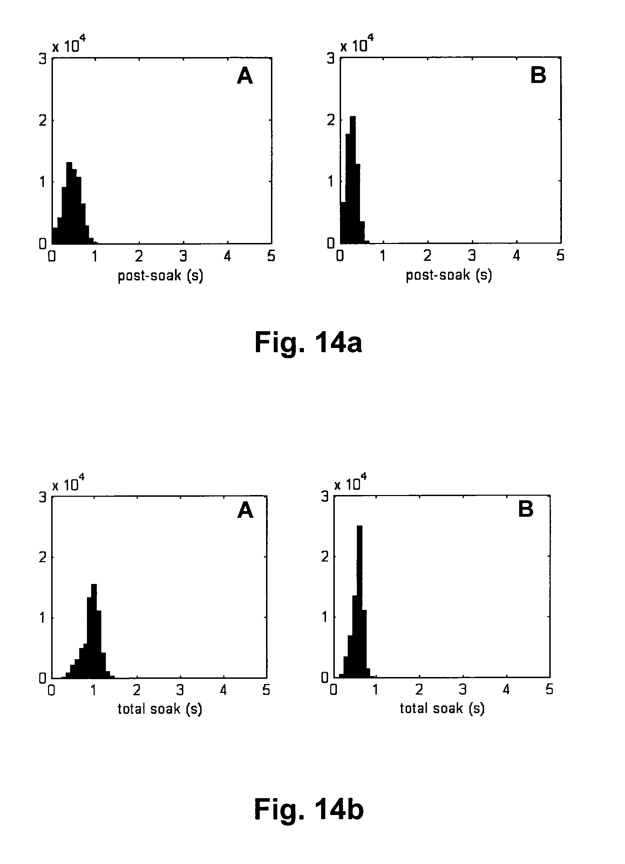

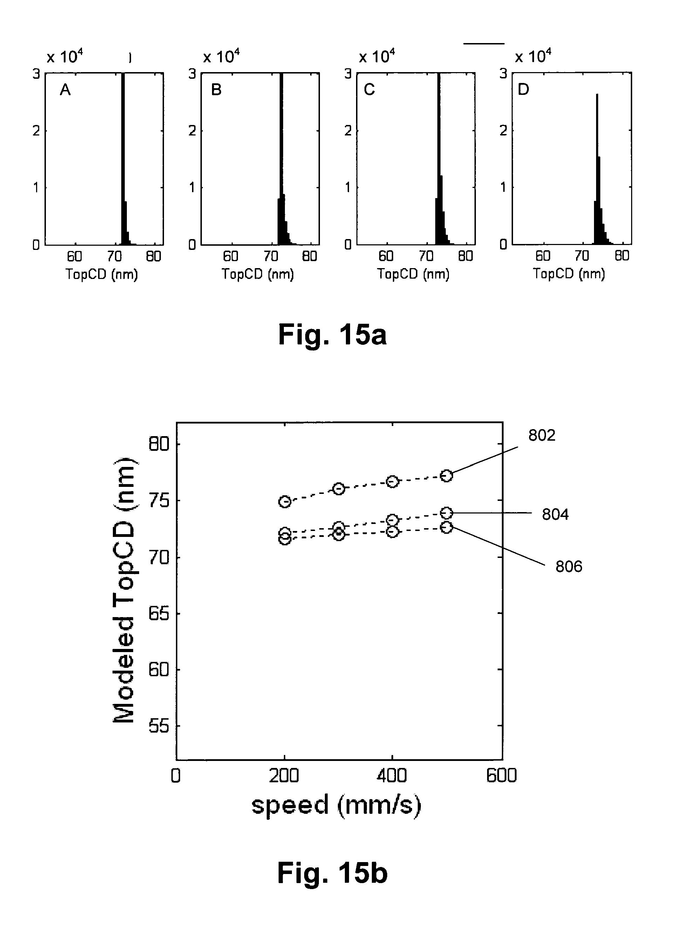

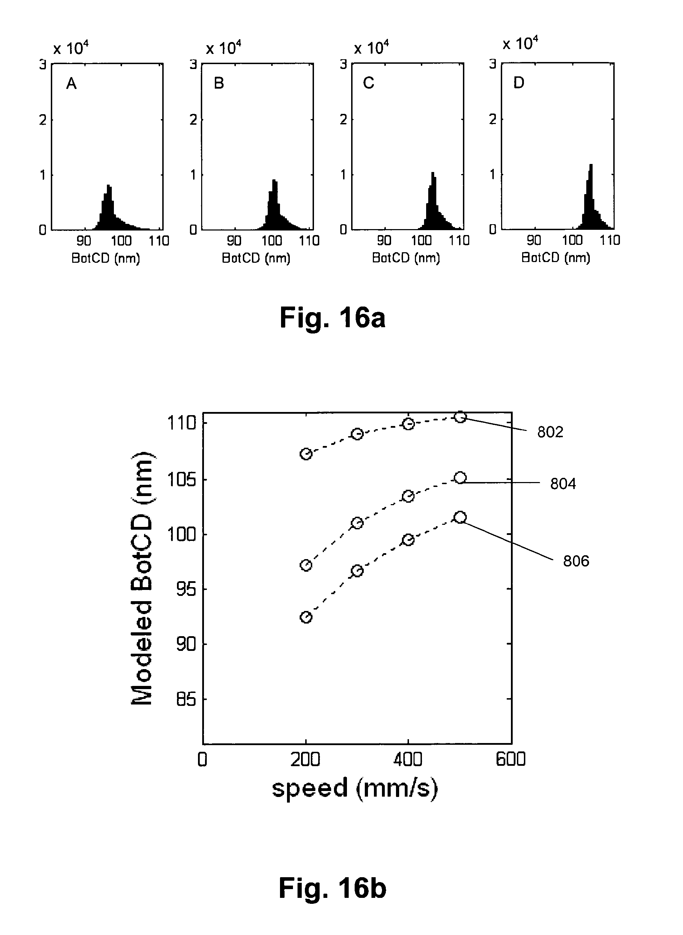

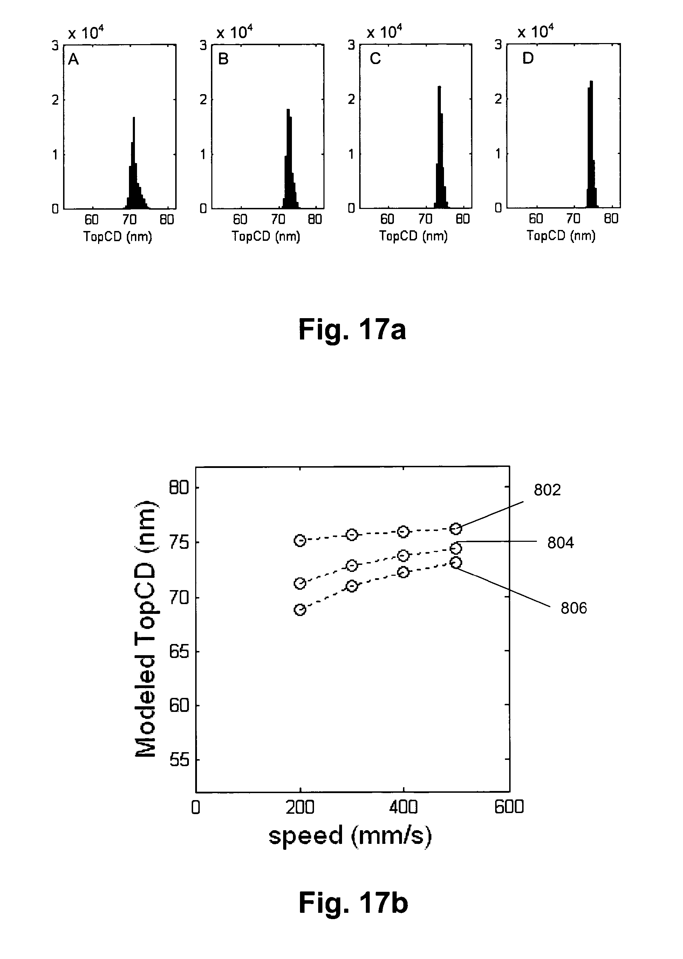

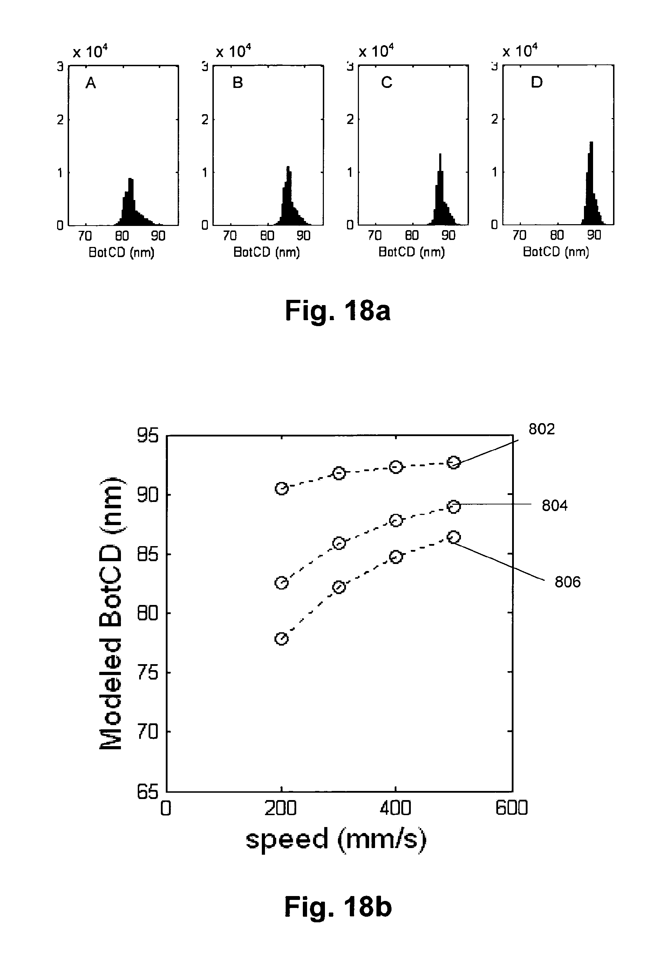

In a fourth example, the use of a model for predicting critical dimension related parameters is illustrated. Based on obtained soak time distributions for different scan speeds in a given immersion lithographic processing of a device, CD at the top of the resist layer and CD at the bottom of the resist layer are modelled for different scan speeds. Fig. 14a and Fig. 14b illustrate the post-soak time respectively total soak-time distribution for an imaged device for the scan speed 300 mm/s (A) and 500mm/s (B). These soak time distributions are determined in similar way as described for the example of Fig. 7a to Fig. 7d. Based on an exponential model as described by equations [4] and [5], the calculated soak time distributions are used for evaluating the CD at the top surface of the resist and the CD at the bottom surface of the resist for immersion lithographic processing of a device using a resist layer PAR 817 with a top coating TCX007 of 104nm thick, i.e. the results shown in Fig. 15a to Fig. 16b, and for a resist layer PAR 817 without top coating, i.e. the results shown in Fig. 17a to Fig. 18b. Fig. 15a and Fig. 17a show the modelled CD at the top surface of the resist for 200mm/s (A), 300 mm/s (B), 400mm/s (C) and 500mm/s (D). Fig. 15b and Fig. 17b show the modelled CD at the top surface of the resist as function of the scan speed, indicating the minimal CD at the top surface of the resist obtained by curve 802, indicating the maximum CD at the top surface of the resist obtained by curve 804 and indicating the mean CD at the top surface of the resist obtained by curve 806. Similar thereto, Fig. 16a and Fig. 18a show the modelled CD at the bottom surface of the resist for 200mm/s (A), 300 mm/s (B), 400mm/s (C) and 500mm/s (D). Fig. 16b and Fig. 18b show the modelled CD at the top surface of the resist as function of the scan speed, indicating the minimal CD at the top surface of the resist obtained by curve 802, indicating the maximum CD at the top surface of the resist obtained by curve 804 and indicating the mean CD at the top surface of the resist obtained by curve 806. From the above provided results, it can be seen that the increase in CD variation towards high scan speeds is limited. The above example illustrates how a model can be used to evaluate an image performance characteristic of a specific immersion lithographic processing of a device.

It is an advantage of embodiments of the present invention that, by using the calculated soak time distribution over the wafer the dimensional variation can be modelled. The modelled variation can be used for process correction in a production environment.

It is to be understood that although preferred embodiments, specific constructions and configurations, as well as materials, have been discussed herein for devices according to the present invention, various changes or modifications in form and detail may be made without departing from the scope and spirit of this invention.

**Claims**

1. A method (300) for setting up immersion lithographic processing of a device (102), said immersion lithographic processing being **characterised by** immersion lithographic processing parameters, said immersion lithographic processing of a device (102) comprising contacting said device (102) with an immersion liquid (114) **characterised by** soak time related parameters, the method comprising,

   - obtaining (302) a value for at least one soak time related parameter based on said immersion lithographic processing parameters,
   - deriving (304) an image performance characteristic for said immersion lithographic processing, using a model for at least one image performance parameter, that is characteristic for said image performance characteristic, as function of said at least one soak time related parameter,
   - evaluating (306) said derived image performance characteristic with respect to a predetermined image performance characteristic criterion; and
   - if said derived image performance characteristic does not fulfil the image performance characteristic criterion, adjusting (308) said immersion lithographic processing parameters based on the derived image performance characteristic.

2. A method (300) according to claim 1, wherein said model is a model based on a spatial distribution of said at least one soak time related parameter.

3. A method (300) according to claim 2, wherein said model is a model based on averaged soak time related parameter values and averaged image performance parameter values, averaged over predetermined image fields taking into account a scan direction of a printing scheme used for obtaining said at least one image performance parameter.

4. A method (300) according to any of claims 1 to 3, wherein said at least one soak time related parameters comprises two independent soak time related parameters.

5. A method (300) according to any of claims 1 to 4, wherein said model is a model based on image performance parameter values corrected for an average field fingerprint.

6. A method (300) according to any of claims 1 to 5, wherein after said adjusting (308) said immersion lithographic processing parameters, the obtaining, deriving and evaluating step is again performed.

7. A method (400) for setting up a model for an image performance characteristic for immersion lithographic processing of a device, the method comprising

   - selecting (402) a calibration immersion lithographic process including a given printing scheme,
   - determining (404) at least one soak time related parameter for said calibration immersion lithographic process
   - quantifying (406), for said calibration immersion lithographic process, an image performance characteristic by determining image performance parameters
   - building (408) a model for said image performance characteristic of said immersion lithographic processing of a device based on deriving a relationship between said quantified image performance parameters and said determined at least one soak time related parameter for said calibration immersion lithographic process.

8. A method (400) according to claim 7, wherein said deriving a relationship between said quantified image performance parameters and said determined at least one soak related parameter is based on averaged soak time related parameter values and averaged image performance parameter values, averaged over predetermined image fields taking into account a scan direction of a printing scheme used for obtaining said at least one image performance parameter.

9. A method for immersion lithographic processing of a device, the lithographic processing being determined by lithographic processing parameter values, said lithographic processing parameters being at least partly selected according to the method of any of claims 1 to 6.

10. A method according to claim 8, said lithographic processing comprising imaging a pattern on said device using a scan path and scan speed and using an exposure dose, wherein any of said scan path, said scan speed or said exposure dose is selected according to the method of any of claims 1 to 6.

11. A processing system (450), the system comprising

- an input means (452) for receiving values for at least one soak time related parameter
- a processing means (454) for deriving an image performance characteristic for the immersion lithographic processing using a model for the image performance characteristic as function of the at least one soak time related parameter
- an evaluation means (456) for evaluating the derived image performance characteristic with respect to a predetermined image performance characteristic criterion, and
- an adjustment means (458) for adjusting the immersion lithographic processing parameters based on the derived image performance characteristic, if said derived image performance characteristic does not fulfil the image performance characteristic criterion.

12. A computer program product for executing a method according to any of claims 1 to 6.

13. A machine readable data storage device storing the computer program product of claim 12.

14. Transmission of the computer program product according to claim 12 over a local or wide area telecommunications network.

**Fig. 1**

**Fig. 2**

300

Receiving value for at least one soak
time related parameter based on
immersion lithographic processing
parameters
302

Deriving image performance
characteristic using model for at least
one image performance parameter
and said at least one soak time
related parameter
304

Evaluating immersion lithographic
processing by evaluating image
performance characteristic
306

Adjusting immersion
lithographic processing
parameters based on derived
image performance
characteristic
308

Determining now soak time
related parameters based on
adjusted immersion
lithographic processing
parameters
310

END
312

**Fig. 3**

400

Selecting a calibration immersion
lithographic process
~402

Determining at least one soak time
related parameter
~404

Quantifying image performance
characteristics
~406

Building model for immersion
lithographic processing based on
derived relation between soak time
related parameter(s) and image
performance parameter(s)
~408

# Fig. 4

## Fig. 5

## Fig. 6a

**Fig. 6b**

**Fig. 7a**

**Fig. 7b**

## Fig. 7c

## Fig. 7d

**Fig. 8**

**Fig. 9**

**Fig. 10a**

**Fig. 10b**

**Fig. 11a**

**Fig. 11b**

**Fig. 11c**

**Fig. 12a**

**Fig. 12b**

**Fig. 13a**

**Fig. 13b**

**-5.3 nm/s**

**Fig. 13c**

**Fig. 14a**

**Fig. 14b**

Fig. 15a

Fig. 15b

**Fig. 16a**

**Fig. 16b**

**Fig. 17a**

**Fig. 17b**

**Fig. 18a**

**Fig. 18b**

**EUROPEAN SEARCH REPORT**

Application Number

EP 05 07 8032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 519 231 A (ASML NETHERLANDS B.V) 30 March 2005 (2005-03-30) * abstract * * figure 1 * * paragraph [0001] * * paragraph [0028] - paragraph [0029] * * paragraph [0034] - paragraph [0035] * * paragraph [0037] * ----- | 1-14 | G03F7/20 |
| X | US 2005/248741 A1 (KAWAMURA DAISUKE ET AL) 10 November 2005 (2005-11-10) * abstract * * figures 1-11 * * paragraph [0003] * * paragraph [0006] * * paragraph [0079] - paragraph [0100] * ----- | 1-14 | |
| A | EP 0 507 589 A (NIKON CORPORATION) 7 October 1992 (1992-10-07) * abstract * * figure 2 * * column 1, line 5 - line 9 * * column 4, line 31 - column 5, line 58 * ----- | 14 | TECHNICAL FIELDS SEARCHED (IPC) H01L G03F |

The present search report has been drawn up for all claims

| Place of search | Date of completion of the search | Examiner |
|---|---|---|
| The Hague | 5 April 2006 | Andersen, O |

## ANNEX TO THE EUROPEAN SEARCH REPORT
## ON EUROPEAN PATENT APPLICATION NO.

EP 05 07 8032

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2006

| Patent document cited in search report | | | Publication date | Patent family member(s) | | | Publication date |
|---|---|---|---|---|---|---|---|
| EP 1519231 | | A | 30-03-2005 | JP | 2005175433 | A | 30-06-2005 |
| | | | | US | 2005094114 | A1 | 05-05-2005 |
| US 2005248741 | A1 | | 10-11-2005 | CN | 1690862 | A | 02-11-2005 |
| | | | | JP | 2005308903 | A | 04-11-2005 |
| EP 0507589 | | A | 07-10-1992 | DE | 69229455 | D1 | 29-07-1999 |
| | | | | DE | 69229455 | T2 | 23-03-2000 |
| | | | | DE | 69233098 | D1 | 17-07-2003 |
| | | | | DE | 69233098 | T2 | 04-12-2003 |
| | | | | JP | 3336436 | B2 | 21-10-2002 |
| | | | | JP | 4305913 | A | 28-10-1992 |
| | | | | US | 5243377 | A | 07-09-1993 |

EPO FORM P0459

For more details about this annex : see Official Journal of the European Patent Office, No. 12/82